Europäisches Patentamt

European Patent Office

Office européen des brevets

(19)

(11) Veröffentlichungsnummer: **0 117 257**
**B1**

# (12) EUROPÄISCHE PATENTSCHRIFT

(45) Veröffentlichungstag der Patentschrift:
07.01.87

(21) Anmeldenummer: **83101723.1**

(22) Anmeldetag: **23.02.83**

(51) Int. Cl.⁴: **H 03 B 9/14**

(54) Stabilisierter Mikrowellenoszillator.

(43) Veröffentlichungstag der Anmeldung:
05.09.84 Patentblatt 84/36

(45) Bekanntmachung des Hinweises auf die Patenterteilung:
07.01.87 Patentblatt 87/2

(84) Benannte Vertragsstaaten:
**AT CH DE LI NL**

(56) Entgegenhaltungen:
**DE - A - 2 710 164**
**DE - A - 2 756 944**
**DE - A - 2 805 254**
**DE - B - 2 826 767**

**NTZ-ARCHIV, Nr. 1, 1979 R. KNÖCHEL et al. "Cavity stabilized oscillators with large tuning range", Seiten 9-13**
**ELECTRONICS LETTERS, Band 11, Nr. 17, 21. August 1975, London R. KNÖCHEL et al. "Design of cavity-stabilised microwave oscillators"**

(73) Patentinhaber: **ANT Nachrichtentechnik GmbH,**
**Gerberstrasse 33, D-7150 Backnang (DE)**

(72) Erfinder: **Tegel, Othmar, Dipl.-Ing.,**
**Geschw.-Scholl-Strasse 13, D-7150 Backnang (DE)**
Erfinder: **Gill, Hardial Singh, Dr. Phil., Tannenweg 2,**
**D-7150 Backnang (DE)**

(74) Vertreter: **Schickle, Gerhard, Dipl.-Ing. et al, ANT**
**Nachrichtentechnik GmbH Patent- und Lizenzabteilung**
**Gerberstrasse 33, D-7150 Backnang (DE)**

**Beschreibung**

Die Erfindung betrifft einen stabilisierten Mikrowellenoszillator gemäss dem Oberbegriff des Patentanspruchs 1. Ein solcher Resonator ist bekannt aus DE-A-2 756 944.

Mikrowellenoszillatoren mit Halbleiterbauelementen, wie GUNN oder IMPATT-Oszillatoren werden häufig auf passive Weise stabilisiert.

Das Grundprinzip besteht darin, das aktive Halbleiterbauelement an einen Resonator mit hoher Güte so anzukoppeln, dass bei vorgegebener konstanter Ausgangsleistung die angestrebte Stabilität und eine einfache Durchstimmung im gewünschten Frequenzbereich erreicht wird (Electronic Letters, 21st August 1975, Vol. 11, Nr. 17, Seiten 405 und 406).

Die Resonanzfrequenz dieser Stabilisierungskreise mit hoher Güte wird durch konstruktive Massnahmen, sowohl von Temperatur- als auch von Luftfeuchteänderungen unabhängig gehalten.

Man kennt drei Möglichkeiten wie der Hauptkreis, der das aktive Element enthält, mit dem Stabilisierungskreis (Resonator) zusammengeschaltet werden kann.

Reaktionsoszillatoren (z.B. Elelctronic Letters, Vol. 11, Nr. 17): Sie ermöglichen hohe belastete Gütefaktoren und relativ hohe Ausgangsleistungen. Der Gütefaktor des Hauptkreises ist verhältnismässig gross. Der Halte- und Durchstimmbereich ist relativ schmal und die Einknopfdurchstimmung über einen vorgegebenen Radiofrequenzbereich ($\geq$ 3% relativen Bandbreite) ist schwer zu realisieren.

Eine zusätzliche Unterdrückung der Schwingfrequenz durch den Stabilisierungskreis erfolgt bei der ausgerasteten Anordnung nicht.

Reflexionsresonatoren (z.B. DE-A-2 805 254; DE-A-2 630 219): Sie haben einen relativ grossen Halte- und Durchstimmbereich und relativ gesehen grössere Ausgangsleistungen. Ungünstig ist, dass sie kleine belastete Güten $Q_L$ haben. Da der Hauptkreis ebenfalls nur geringe Güten hat, ist die Temperaturstabilisierung schwieriger. Es erfolgt auch keine Unterdrückung der Schwing-Frequenz bei ausgerastetem Oszillator.

Transmissionsresonatoren (z.B. DE-A-2 356 445; DE-A-2 756 944; IEEE Proceedings Letters, 1970, Vol. 58, S. 831 und 832): Sie bringen wegen der zusätzlichen Durchgangsverluste bei gleichem Halbleiter-Bauelement kleinere Ausgangsleistungen als die Reaktions- oder Reflexionsgeneratoren. Sie haben mittlere belastbare Güten $Q_L$. Der Halte- und Durchstimmbereich ist gut. Frequenzänderungen (5... 10% rel. Bandbreite) mit Einknopfbedienung durch Verstimmen eines temperaturkompensierten Stabilisierungskreises sind hier am leichtesten zu realisieren. Beim Transmissionsresonator gemäss DE-A-2 756 944 ist ein $\lambda/2$ langes Koppelmittel zwischen aktivem Element und Resonator vorgesehen, welches mit einer Frequenz nahe der Hohlleitergrenzfrequenz betrieben wird. Dieses bringt jedoch eine grosse Dämpfung für den Oszillator mit sich.

Die Schwingfrequenz eines ausgerasteten Oszillators soll möglichst zusätzlich unterdrückt werden. Dies kann auch bei Reaktanz- und Reflexionsresonatoren eventuell durch zusätzliche Überwachungen und einer damit gekoppelten Abschaltung des Oszillators erfolgen, so dass in jedem Fall die Aussendung einer falschen Frequenz verhindert wird. Dies bedeutet einen zusätzlichen, oft bedeutenden Schaltungsaufwand.

Aufgabe der Erfindung ist es, einen durch den Oberbegriff des Patentanspruchs 1 näher bezeichneten Mikrowellenoszillator so auszugestalten, dass ihm bezüglich eines in der Stabilität vergleichbaren Oszillators mehr Ausgangsleistung entnommen werden kann unter Gewährleistung einer guten Durchstimmbarkeit.

Erfindungsgemäss wird diese Aufgabe durch die kennzeichnenden Merkmale des Patentanspruchs 1 gelöst.

In den Unteransprüchen sind vorteilhafte Ausgestaltungen der Erfindung aufgezeigt.

Aus der DE-A-2 630 219 wie auch der DE-A-2 756 944 ist es zwar bekannt, bei einem Mikrowellenoszillator, der einen Durchgangsresonator zur Stabilisierung aufweist, eine $\lambda/2$ lange Koppelleitung zwischen dem Resonator und jenem Hohlleiter vorzusehen, welcher das aktive Halbleiterbauelement enthält, jedoch ist es mit diesem Oszillator wegen der vorhandenen Dämpfung nicht möglich, unter Beibehaltung der Stabilität eine höhere Leistung zu entnehmen.

Anhand der Zeichnungen wird die Erfindung nun näher erläutert. Es zeigen:

Fig. 1a und b den konstruktiven Aufbau des Mikrowellenoszillators,

Fig. 2 ein elektrisches Ersatzschaltbild des Mikrowellenoszillators und

Fig. 3 eine spezielle Diodenhalterung.

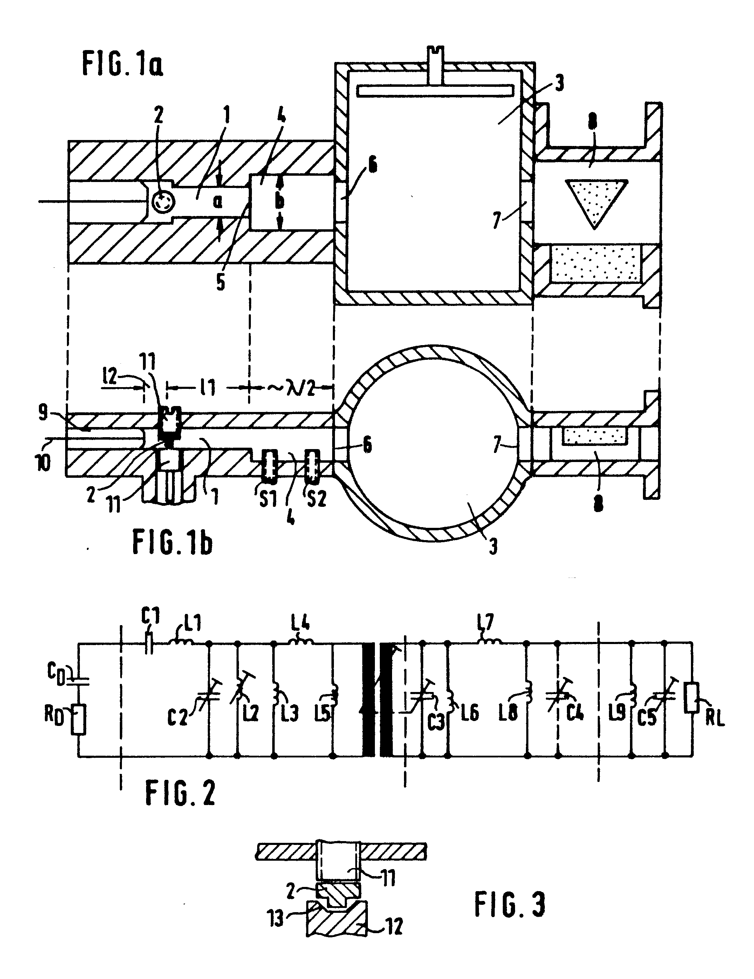

Fig. 1 zeigt den Mikrowellenoszillator in einem waagrechten — Fig. 1a — und senkrechten Schnitt — Fig. 1b —. Der Hauptkreis des Oszillators als das die Frequenz mitbestimmendes Element besteht aus einem rechteckförmigen Hohlleiter 1. Er ist als Sperrwellenhohlleiter ausgebildet, d.h. für den Betriebsfrequenzbereich ist er unterhalb der Grenzfrequenz betrieben. Der Hohlleiter 1 weist im wesentlichen die Länge $\ell 1$ und die Breite a auf. In seinem einen Endbereich ist das aktive Halbleiterbauelement 2, eine GUNN- oder IMPATT-Diode, angeordnet.

Als Stabilisierungsresonator 3 ist vorzugsweise wegen seiner hohen Leerlaufgüte ein kreiszylindrischer Resonator von $H_{01q}$-Schwingungstyp, vorzugsweise $H_{012}$, vorgesehen. Damit der Resonator sowohl gegen Temperatur-, Luftdruck- und Luftfeuchtigkeitsschwankungen unempfindlich ist, ist er temperaturkompensiert und beispielsweise mit einem trockenen Gas gefüllt.

Der Stabilisierungsfaktor S des Oszillators mit eindeutiger Abstimmcharakteristik ist

$$S = \frac{Q_L \text{ stab}}{Q_L \text{ unstab}}.$$

Geht man von einem hinsichtlich seiner Leistung und seiner Frequenz gegebenen Halbleiterbauelement wie einer GUNN- oder IMPATT-Diode aus, so ist noch der zugehörige Gütefaktor $Q_D$ des aktiven Elementes von Bedeutung, weil er einen grossen Einfluss auf die belastete bzw. externe Güte des Hauptresonators und damit auf die technischen Eigenschaften des Gesamtoszillators hat.

Generell kann man sagen, dass mit zunehmender Leistung und Frequenz die Güte des aktiven Elementes ansteigt, was automatisch bei gleicher Schaltungsanordnung zu einer höheren unstabilisierten Güte $Q_L$, unstab. führt.

Das Koppelmittel 4 zwischen Resonator 3 und Sperrwellenhohlleiter 1 besteht aus einem etwa $\lambda/2$ langen Hohlleiterstück, welches mindestens zum Teil als Sperrwellenhohlleiter und/oder als Hohlleiter nahe der Grenzfrequenz ausgebildet ist. Als Sperrwellenhohlleiter ist ein unterhalb der Grenzfrequenz betriebener Hohlleiter zu verstehen. Für die $H_{01}$-Welle gilt: $\lambda_{Gr} = 2a$. Die Abmessungen dieses Hohlleiterstücks 4 sind so gewählt, dass die Grenzfrequenz nahe der Betriebsfrequenz liegt. Es hat sich als vorteilhaft erwiesen, das Hohlleiterstück 4 so zu dimensionieren, dass seine Grenzfrequenz knapp unterhalb bzw. knapp oberhalb der Betriebsfrequenz liegt, beispielsweise 1 bis 10%. Das Hohlleiterstück 4 sorgt für eine optimale Verbindung des Sperrwellenhohlleiters 1 — Hauptkreis — mit dem Stabilisierungsresonator 3 und übt einen wesentlichen Einfluss auf die Eigenschaften des Gesamtoszillators aus, insbesondere auf die Ausgangsleistung, den Stabilisierungsfaktor S, den Zieh- und Haltebereich und das Anschwingverhalten.

Das Hohlleiterstück 4 kann entweder auf seiner gesamten Länge als Sperrwellenhohlleiter oder auch nur teilweise als Sperrwellenhohlleiter ausgebildet sein.

Der Übergang vom unterhalb der Grenzfrequenz betriebenen rechteckförmigen Hohlleiter 1 zu dem zumindest teilweise als Sperrwellenhohlleiter ausgebildeten Hohlleiterstück 4 erfolgt durch einen HE-Sprung 5; d.h. die Breitseite des Hohlleiters 1 wird zur Schmallseite b des Hohlleiterstücks 4. Das Hohlleiterstück 4 kann auch noch weitere Sprünge aufweisen. Zur Welleneinkopplung zwischen Hohlleiterstück 4 und Resonator 3 dient eine Blende 6. Eine ebensolche Blende ist auf der gegenüberliegenden Seite des Resonators 3 angebracht. Sie ist mit dem Bezugszeichen 7 bezeichnet. Eine ihr nachgeschaltete Richtungsleitung 8 dient zur Entkopplung des Oszillators von der Last. Da die Welle aus dem Resonator 3 nicht über die Blende 6 ausgekoppelt wird, sondern über eine getrennte Blende 7, handelt es sich beim Resonator 3 um einen Durchgangsresonator. Dadurch ist eine zusätzliche Unterdrückung der Welle bei ausgerastetem Zustand möglich.

In das Hohlleiterstück 4 kann zur Bedämpfung unerwünschter Resonanzen zusätzlich Dämpfungsmaterial eingefügt sein. Zur Veränderung der Kopplung zwischen Hauptkreis — Hohlleiter 1 — und Stabilisierungskreis — Resonator 3 — kann das Koppelmittel — Hohlleiterstück 4 — ein oder mehrere Abstimmstifte S1, S2, beispielsweise Abstimmschrauben, enthalten. Diese Abstimmstifte S1 und S2 sind vorzugsweise im Abstand von etwa $\lambda/8$ oder $\lambda/4$ anzuordnen.

Am oberen Ende des Sperrwellenhohlleiters 1, d.h. am dem Hohlleiterstück 4 gegenüberliegenden Anschlussende, ist ein weiterer Sperrwellenhohlleiter 9 angeordnet. Er enthält einen Kurzschlussschieber 10, der ihm veränderbares Induktivitätsverhalten verleiht. Dieser weitere Sperrwellenhohlleiter 9 kann entweder die gleichen, oder andere Abmessungen wie der Sperrwellenhohlleiter 1 in der Diodenzone haben. Er kann z.B. auch einen runden Querschnitt haben, wobei der Kurzschlussschieber 10 durch eine kontaktgebende Schraube gebildet wird. Die effektive Länge des weiteren Sperrwellenhohlleiters 9 ist mit $\ell 2$ bezeichnet. Wichtig bei dieser Anordnung ist ausserdem die Ausbildung des Sperrwellenhohlleiters 1 in unmittelbarer Nähe der Halbleiterbauelemente 2, sowie die Ausbildung der Gleichspannungszuführung. Die Gleichspannung wird über ein- oder mehrkreisige koaxiale Sperrfilter 11 zugeführt.

Je nach verwendetem Halbleiterbauelement 2 kann die Gleichspannungsversorgung aus Konstant-, Strom- oder Spannungsquellen erfolgen. Die Stromversorgungen können zusätzlich Begrenzungsschaltungen und Schaltungen die das Anschwingverhalten des Oszillators verbessern enthalten.

Der passiv stabilisierte Oszillator kann zur Übertragung von Signalen über den Strom oder die Spannung des Halbleiterbauteils moduliert werden.

Zur Halterung des Halbleiterbauelements 2 weist der Hohlleiter 1 einen Schraubstift 11 auf (Fig. 1b und 3), der gegen das Halbleiterbauelement 2 zur Kontaktgabe gedrückt werden kann, und einen Stempel 12 über den das Halbleiterbauelement 2 Gleichspannungspotential zugeführt bekommt. Im Bereich des Halbleiterbauelements 2 kann der Hohlleiter 1 besonders geformt sein (Stege). Ebenfalls kann der Stempel 12 am halbleiterbauelementseitigen Ende eine besondere Formung aufweisen (Einsenkung 13 in Fig. 3). Diese Massnahmen tragen dazu bei, dass der Hohlleiter 1 zwei- oder mehrkreisiges Resonanzverhalten mit unterkritischer Kopplung aufweist.

Die Dimensionierung der Hohlleiter 1 und 4 bestimmt die Realteiltransformation und die Ankopplung an den Stabilisierungskreis. Die Verwendung von Sperrwellenhohlleitern für die Hohlleiter 1 und 4 bietet insofern Vorteile, als das Verhalten dieser Leitungen im HF-Bereich wie das von konzentrierten Elementen ist. Ferner sind die Verluste klein und die Schaltungen sind breitbandig, da z.B. beim Einbau der Dioden keine parasitären Blindelemente auftreten.

Es besteht kein periodischer Zusammenhang zwischen Blindwiderstand und Frequenz. Die Ausbreitungskonstante $\gamma_e$ des Grundschwingungstyps (abklingende $H_{10}$-Welle) ist reell, der Wellenwiderstand positiv imaginär ($Zo = jXo$). Die meisten Hindernisse im Sperrwellenhohlleiter stellen Induktivitäten dar. Die Ausnahme sind Schrauben oder Pfosten die einen Schlitz bilden, und dünne Scheiben aus dielektrischem Material. Sie wirken als Kapazitäten. Für den Stabilisierungskreis 3 wird wegen der hohe Güte vorzugsweise ein Resonator vom Typ $H_{0q}$ verwendet.

Das Ersatzschaltbild des Oszillators ist in Fig. 2 dargestellt.

$C_D$ und $-R_D$ bilden das vereinfachte Ersatzschaltbild des Halbleiterbauelements 2. C1, L1, C2 werden durch die Art der Diodenhalterung bestimmt. Dabei spielt die Ausbildung des diodenseitigen Endes des Sperrfilters 11 eine wichtige Rolle. $L_2$ wird durch die Abmessungen der Leitung 9 und die Stellung des Kurzschlussschiebers 10 festgelegt ($XL_2 = jXo \tanh \gamma_e l_2$). Die Diode, C1, L1, C2, L2 bilden im gezeigten Einsatzschaltbild eine unterkritisch bis kritisch gekoppeltes zweikreisiges Filter. Diese Anordnung kann auch mehrkreisig aufgebaut werden. L3, 4, L5 ist in Verbindung mit dem HE-Sprung zum Hohlleiterstück 4 im wesentlichen hinsichtlich der Realteiltransformation dimensioniert ($XL_4 = jXo \sinh \gamma_e l_1$, $XL_3$, $XL_5 = jXo \coth \gamma_e l_1$). C3 wird durch die Abstimmschraube S1 bestimmt. Sie ermöglicht ausserdem bei geeignetem Durchmesser und Abstand vom HE-Sprung eine Änderung der Realteiltransformation.

Das Hohlleiterstück 4 wird durch L6, L7, L8 gebildet. Es hat bei Ausbildung als Sperrwellenhohlleiter im Prinzip ebenfalls die oben gezeigte Abhängigkeit. C4 wird durch S2 gegeben.

L9 und C5 stellen den Stabilisierungskreis 3 dar. Das Verhalten dieser Kreise ist natürlich nicht wie das von konzentrierten Elementen ($H_{01q}$-Resonanz). Im Ersatzschaltbild ist die Richtungsleitung 8 weggelassen. Der Lastwiderstand ist durch RL dargestellt.

Ein für ein Richtfunkgerät mit einem Radiofrequenzbereich von 14,5 bis 15,35 GHz ausgeführter Oszillator erreichte bei Einsatz einer GaAs-Impatt-Diode mit einer Ausgangsleistung von 2 bis 2,5 Watt einen Gesamtwirkungsgrad von grösser 5%. Die Frequenzstabilität war besser als $\pm 5 \cdot 10^{-5}$.

Dies entspricht einer Stabilität von $6,25 \cdot 10^{-7}/°C$ für einen Umgebungstemperaturbereich von —25°C bis +55°C und einem relativen Luftfeuchtebereich von 10 bis 90%.

**Patentansprüche**

1. Stabilisierter Mikrowellenoszillator, bestehend aus einem rechteckförmigen Hohlleiter (1), in welchem mindestens ein aktives Halbleiterbauelement (2) mit Gleichspannungszuführung angeordnet ist, einem Durchgangsresonator (3) und einem den Durchgangsresonator (3) mit dem rechteckförmigen Hohlleiter (1) verbindeden Koppelmittel (4), welches aus einem Hohlleiterstück mit einer Länge von etwa $\lambda/2$ ($\lambda$ = Wellenlänge der Betriebsfrequenz) besteht, und welches eine Hohlleitergrenzfrequenz nahe der Resonanzfrequenz des Resonators (3) aufweist, dadurch gekennzeichnet, dass der das aktive Halbleiterbauelement (2) aufnehmende Hohlleiter (1) unterhalb der Grenzfrequenz betrieben wird, dass das Koppelmittel (4) zumindest teilweise als Sperrwellenhohlleiter ausgebildet ist, und dass der unterhalb der Grenzfrequenz betriebene rechteckförmige Hohlleiter (1) mit Schaltmitteln (C1, L1, C2, L2), die im wesentlichen durch die Halterung des Halbleiterbauelements und durch das Halbleiterbauelement (2) selbst bestimmt sind, derart beschaltet ist, dass er zwei- oder mehrkreisiges Resonanzverhalten mit unterkritischer Kopplung aufweist.

2. Mikrowellenoszillator nach Anspruch 1, dadurch gekennzeichnet, dass der Übergang vom unterhalb der Grenzfrequenz betriebenen rechteckförmigen Hohlleiter (1) zu dem zumindest teilweise als Sperrwellenhohlleiter ausgebildeten Hohlleiterstück (4) durch einen HE-Sprung (5) erfolgt.

3. Mikrowellenoszillator nach Anspruch 1 oder 2, dadurch gekennzeichnet, dass das zumindest teilweise als Sperrwellenhohlleiter ausgebildete Hohlleiterstück (4) einen oder mehrere Abstimmstifte (S1, S2) aufweist.

4. Mikrowellenoszillator nach Anspruch 3, dadurch gekennzeichnet, dass die Abstimmstifte einen Abstand von etwa $\lambda/8$ oder $\lambda/4$ aufweisen.

5. Mikrowellenoszillator nach einem der Ansprüche 1, 2 oder 3, dadurch gekennzeichnet, dass das zumindest teilweise als Sperrwellenhohlleiter ausgebildete Hohlleiterstück (4) Dämpfungsmaterial enthält.

6. Mikrowellenoszillator nach Anspruch 1, dadurch gekennzeichnet, dass an das dem zumindest teilweise als Sperrwellenhohlleiter ausgebildeten Hohlleiterstück (4) gegenüberliegende Ende des rechteckförmigen Hohlleiters (1) ein weiterer Sperrwellenhohlleiter (9) angeschlossen ist und dass dieser weitere Sperrwellenhohlleiter (9) einen Kurzschlussschieber (10) enthält, der ihm veränderbares Induktivitätsverhalten verleiht.

**Claims**

1. Stabilized microwave oscillator, comprising a rectangular waveguide (1), in which is disposed at least one active semiconductor component (2) having a direct voltage input, the microwave oscillator further comprising a transmission resonator (3) and a coupling means (4) composed of a waveguide section having a length of about $\lambda/2$ ($\lambda$ = wavelengt of the operating frequency) and a waveguide limit frequency near the resonant frequency of the resonator (3) for connecting the transmission resonator (3) with the rectangular waveguide (1), characterized in that the waveguide (1) accomodating the active semiconductor component (2) is operated below the limit frequency; the coupling means (4) is configured, at least in part, as a mode blocking waveguide; and the rectangular waveguide (1) operated below the limit frequency is equipped with switching means (C1, L1, C2, L2) determined essentially by the semiconductor component mount and by the semiconductor component (2) itself so that said waveguide exhibits dual circuit or multicircuit resonant behavior with subcritical coupling.

2. Microwave oscillator according to claim 1, characterized in that the transition from the rectangular waveguide (1) operated below the limit frequency to the waveguide section (4) configured at least in part as a mode blocking waveguide is effected by way of an HE change (5).

3. Microwave oscillator according to claim 1 or 2, characterized in that the waveguide section (4) which is configured at least in part as a mode blocking waveguide includes one or a plurality of tuning pins (S1, S2).

4. Microwave oscillator according to claim 3, characterized in that the tuning pins are spaced by approximately $\lambda/8$ or $\lambda/4$.

5. Microwave oscillator according to one of claims 1, 2 or 3, characterized in that the waveguide section (4) which is configured at least in part as a mode blocking waveguide contains damping material.

6. Microwave oscillator according to claim 1, characterized in that the end of the rectangular waveguide (1) disposed opposite the waveguide section (4) which is configured at least in part as a mode blocking waveguide is connected to a further mode blocking waveguide (9) and said further mode blocking waveguide (9) includes a shorting plunger (10) which imparts a variable inductance behavior to said further mode blocking waveguide.

**Revendications**

1. Oscillateur à micro-ondes stabilisé, comprenant un guide d'ondes rectangulaire creux (1) dans lequel est disposé au moins un composant semi-conducteur actif (2), auquel est appliquée une tension continue, un résonateur à transmission (3) et un dispositif de couplage (4), reliant le résonateur à transmission (3) au guide d'ondes rectangulaire (1), dispositif de couplage qui est constitué d'un tronçon de guide d'ondes creux de longueur d'environ $\lambda/2$ ($\lambda$ = longueur d'onde de la fréquence de service) et qui présente une fréquence limite de guide d'ondes proche de la fréquence de résonance du résonateur (3), caractérisé en ce que le guide d'ondes (1) recevant le composant semi-conducteur (2) est utilisé au-dessous de la fréquence limite, que le dispositif de couplage (4) est réalisé en partie au moins comme un guide d'ondes de blocage et que le guide d'ondes rectangulaire (1), utilisé au-dessous de la fréquence limite, est muni de dispositifs de commutation (C1, L1, C2, L2), déterminés essentiellement par le support du composant semi-conducteur et par le composant semi-conducteur (2) lui-même, de telle manière qu'il présente un comportement de résonance à deux ou davantages de circuits à couplage sous-critique.

2. Oscillateur selon la revendication 1, caractérisé en ce que la transition du guide d'ondes rectangulaire (1), utilisé au-dessous de la fréquence limite, au tronçon de guide d'ondes (4), réalisé en partie au moins comme un guide d'ondes de blocage, est réalisée au moyen d'une discontinuité HE (5).

3. Oscillateur selon la revendication 1 ou 2, caractérisé en ce que le tronçon de guide d'ondes (4), réalisé en partie au moins comme un guide d'ondes de blocage, présente une ou plusieurs tiges d'accord (S1, S2).

4. Oscillateur selon la revendication 3, caractérisé en ce que les tiges d'accord ont un écartement d'environ $\lambda/8$ ou $\lambda/4$.

5. Oscillateur selon une des revendications 1, 2 et 3, caractérisé en ce que le tronçon de guide d'ondes (4), réalisé en partie au moins comme un guide d'ondes de blocage, contient du matériau d'affaiblissement.

6. Oscillateur selon la revendication 1, caractérisé en ce qu'un autre guide d'ondes de blocage (9) est raccordé à l'extrémité du guide d'ondes rectangulaire (1) située à l'opposé du tronçon de guide d'ondes (4) réalisé en partie au moins comme un guide d'ondes de blocage, et que cet autre guide d'ondes de blocage (9) contient une coulisse de court-circuit (10) qui lui confère un comportement d'inductance variable.

FIG.1a

FIG.1b

FIG.2

FIG.3